# DEMANDE DE BREVET EUROPEEN

(11) **EP 1 772 905 A1**
(43) Date de publication de la demande: **11.04.2007**
(21) Numéro de dépôt: 06026986.7
(22) Date de dépôt: 14.03.2000
(51) Int. Cl.: H01L 29/165, H01L 21/20, H01L 31/0352, H01L 31/072, H01L 31/18, H01L 33/00, H01L 21/205, H01L 21/336, H01L 21/321

(54) **Procédé de fabrication d'une hétérostructure planaire**

(30) Priorité: 31.03.1999 FR 9904052
(62) Demande divisionnaire de: 00400703.5
(71) Demandeur: Fahrenheit Thermoscope LLC, Las Vegas, NV 89119 (US)
(72) Inventeur: Hernandez, Caroline, 38000 Grenoble (FR); Campidelli, Yves, 38000 Grenoble (FR); Rivoire, Maurice, 38240 Meylan (FR); Bensahel, Daniel, 38000 Grenoble (FR)
(74) Mandataire: Casalonga, Axel

(57) **Abrégé**

Le procédé comprend :
la gravure dans un substrat semiconducteur (2), d'au moins une tranchée (3) de largeur et de profondeur prédéterminées ;
le dépôt sur le substrat et dans la tranchée d'un empilement de couches successives et alternées de Si_{1-X}Ge_{X} (0 < x ≤ 1) et Si (5-8) dont le nombre et l'épaisseur dépendent de l'utilisation finale envisagée pour l'hétérostructure;et
le polissage mécano-chimique pour obtenir une hétérostructure finale ayant une surface principale supérieure plane au niveau de laquelle affleurent les couches de l'empilement déposées dans la tranchée.

Application à la microélectronique

## Description

La présente invention concerne d'une manière générale un procédé de réalisation d'une hétérostructure planaire pour la fabrication de dispositifs électroniques et/ou optoélectroniques, en particulier dans l'industrie de la microélectronique.

Une des étapes cruciales et souvent limitante des procédés de fabrication des circuits intégrés est l'étape de gravure par photolithographie. Pour réaliser des motifs très minces, typiquement de largeur inférieure à 100 nm, les techniques photolithographiques nécessiteront des équipements très lourds tant financiers que consommateurs de temps, comme l'insolation optique au moyen de rayons X ou l'écriture directe par faisceau électronique.

Il serait donc souhaitable de pouvoir s'affranchir autant que possible pour la fabrication de tels dispositifs microélectroniques, et en particulier pour les dispositifs optoélectroniques, de l'étape de photolithographie.

On a maintenant trouvé qu'il était possible de s'affranchir ou de contourner l'étape photolithographique pour réaliser des motifs en matériau actif (grille d'un CMOS ou couche d'un multi- puits quantiques, par exemple) de largeur prédéterminée très mince en utilisant le très bon contrôle en épaisseur des dépôts. Une telle approche rend possible la réalisation de dispositifs planaires (principalement optoélectroniques), c'est-à-dire en surface de l'échantillon et non plus dans l'épaisseur.

Selon l'invention, le procédé de fabrication d'une hétérostructure planaire comprend :
a) 1a gravure dans un substrat semiconducteur, à partir d'une surface principale supérieure du substrat,d'au moins une tranchée de largeur et de profondeur prédéterminées ayant une paroi de fond et des parois latérales verticales;
b) le dépôt sur la surface principale supérieure du substrat et les parois de fond et latérales de la tranchée d'un empilement de couches successives et alternées de Si₁₋ₓGeₓ (0 < x ≤ 1) et Si dont le nombre et l'épaisseur dépendent de l'utilisation finale envisagée pour l'hétérostructure; et
c) le polissage mécano-chimique pour obtenir une hétérostructure finale ayant une surface principale supérieure plane au niveau de laquelle affleurent les couches de l'empilement déposées dans la tranchée.

Dans une première mise en oeuvre du procédé de l'invention l'empilement de couches successives alternées ne remplit pas la tranchée en totalité et avant l'étape de polissage mécano-chimique on procède au dépôt d'une couche d'un matériau diélectrique pour finir le remplissage de la tranchée.

Dans une seconde mise en oeuvre du procédé de l'invention, l'empilement des couches successives alternées dans la tranchée est réalisé de manière à laisser un évidement , par exemple central , dans la tranchée et on procède, avant le polissage mécano-chimique, à une gravure de l'empilement de manière à prolonger l'évidement jusque dans le matériau du substrat. On procède alors au dépôt d'un matériau diélectrique pour remplir l'évidement prolongé et au polissage mécano-chimique pour obtenir l'hétérostructure planaire finale.

Dans une troisième mise en oeuvre du procédé de l'invention,préalablement au dépôt de l'empilement,on dépose dans la tranchée une couche de matériau diélectrique remplissant cette'dernière et on effectue la gravure du matériau diélectrique de façon à former dans la tranchée une cloison, par exemple centrale, divisant la tranchée en deux demi tranchées et on remplit les deux demi tranchées en réalisant le dépôt d'un empilement de couches successives alternées.

Les substrats convenant pour la présente invention sont les substrats en silicium massif ou en couche mince, par exemple silicium sur isolant (SSI), ou en germanium massif ou en couche mince.

Bien évidemment le procédé de l'invention peut comporter la réalisation de plusieurs tranchées dans le substrat en fonction de l'application envisagée pour le dispositif. Les tranchées peuvent être de largeurs identiques ou différentes selon l'application.Egalement la profondeur des tranchées variera en fonction de l'application.

Les parois latérales (flancs) des tranchées sont de préférence verticales, c'est-à-dire le plus proche possible de la direction cristallographique <100> et généralement à un angle de 70° à 80° par rapport au plan de la surface principale supérieure du substrat.Si les flancs des tranchées ne sont pas verticaux, alors on n'obtiendra pas lors du dépôt ultérieur de l'empilement des couches d' épaisseur uniforme sur les flancs, sommets et fonds des tranchées. En outre,les zones en coin au fond ou au sommet des tranchées sont des zones sensibles dans la mesure ou la croissance des couches de l'empilement dans ces zones, bien que conforme, est perturbée. Il est donc préférable d'éloigner ces zones des futures zones actives, par exemple en réalisant des tranchées plus profondes, c'est-à-dire ayant un rapport d'aspect p/e élevé (p=profondeur et e=largeur). De préférence encore les flancs des tranchées seront de qualité monocistalline, c'est-à-dire qu'après la gravure on procèdera à une oxydation des surfaces de la tranchée puis à l'enlèvement de la couche d'oxyde,par exemple par dissolution, pour obtenir des surfaces sans défauts.

Les tranchées peuvent être réalisées par tout procédé classique tel que la photolithogravure au moyen d'un masque.

Le dépôt des couches minces alternées Si₁₋ₓGeₓ et Si est en général un dépôt par hétéro-épitaxie ou épitaxie par voie de dépôt chimique en phase vapeur (CVD). Si le substrat de départ est du silicium ou du silicium sur isolant, la concentration en Ge de l'alliage Si₁₋ₓGeₓ immédiatement déposée sur le substrat peut varier de quelques pourcents à 100% atomique. Néanmoins l'épaisseur de la couche sera telle que cette couche est contrainte sur le substrat de silicium, c'est-à-dire inférieure à l'épaisseur critique au-delà de laquelle la couche se relaxe en émettant des dislocations .Et réciproquement dans le cas d'un dépôt de Si₁₋ₓGeₓ riche en Si sur un substrat de germanium. Le dépôt des différentes couches est réalisé dans des conditions de température, pression, flux d'espèces gazeuses actives permettant d'obtenir une conformité du dépôt, c'est-à-dire une épaisseur constante de chaque film sur la surface, les flancs et le fond de la tranchée. De la précision de l'épaisseur des films sur les flancs de la tranchée dépendra en effet le résultat final en "largeur de trait". Ces dépôts peuvent être réalisés au moyen d'une machine industrielle classique d'épitaxie monoplaque qui s'avère particulièrement appropriée pour former les multicouches Si₁₋ₓGeₓ/Si voulus. On utilisera de préférence des dépôts en régime de surface, c'est-à-dire un régime de dépôt dans lequel c'est la couverture de la surface qui règle l'avancée des réactions chimiques (par opposition au régime de diffusion). Ainsi, avec des gaz précurseurs tels que SiH₄, GeH₄ et H₂ (ce dernier jouant également le rôle de gaz porteur), on peut utiliser des températures de dépôt variant de 450 à 700°C. Pour obtenir un dépôt conforme,surtout avec des rapports d'aspect élevés, il est préférable d'effectuer le dépôt avec une pression totale faible, typiquement de l'ordre de 2,6 kPa (20 Torr).Toutefois, on peut utiliser des pressions plus élevées allant jusqu'à la pression atmosphérique.

Pour certaines applications, on peut déposer de manière classique, par exemple par CVD, sur la structure avec tranchées remplies,une couche d'un matériau diélectrique, planarisant ou non, tel que SiO₂ ou Si₃N₄.

Eventuellement, les couches épitaxiées ou hétéro-épitaxiées dans les tranchées peuvent être dopées avec un dopant de type n ou p selon l'architecture voulue.

Après les dépôts des différentes couches,on procède au polissage mécano-chimique(PMC) pour faire affleurer les couches à la surface du substrat. On peut utiliser tout procédé PMC classique, les conditions étant déterminées de manière à obtenir une surface plane quelque soit l'architecture.

Enfin pour encore d'autres applications, on pourra après PMC redéposer sur la surface polie des couches de matériaux tels que Si, SiGe ou diélectriques, par exemple par épitaxie classique.

La suite de la description se réfère aux figures annexées qui représentent respectivement:
Figures 1a à 1d, des vues schématiques en coupe (figures 1a à 1c) et en perspective (figure 1d) des étapes principales d'un mode de mise en oeuvre du procédé de l'invention ;
Figures 2a à 2d, des vues schématiques en coupe (figures 2a à 2d) et en perspectives (figure 2e) des étapes principales d'un second mode de mise en oeuvre du procédé de l'invention ; et
Figures 3a à 3d, des vues schématiques en coupe des étapes principales d'un troisième mode de mise en oeuvre du procédé de l'invention.

En se référant aux figures 1a à 1d, on va maintenant décrire un premier mode de mise en oeuvre du procédé de l'invention.

Après avoir formé de manière classique, par exemple par épitaxie, sur un substrat 1 tel qu'un substrat "isolant sur silicium (SSI)" comprenant une couche de silicium 1a et une couche d'oxyde de silicium 1b, une couche de silicium ou de germanium 2, on grave de manière classique dans cette couche 2 des tranchées 3 ayant un rapport d'aspect prédéterminé p/e, mais qui peut varier d'une tranchée à l'autre en fonction du dispositif final voulu.

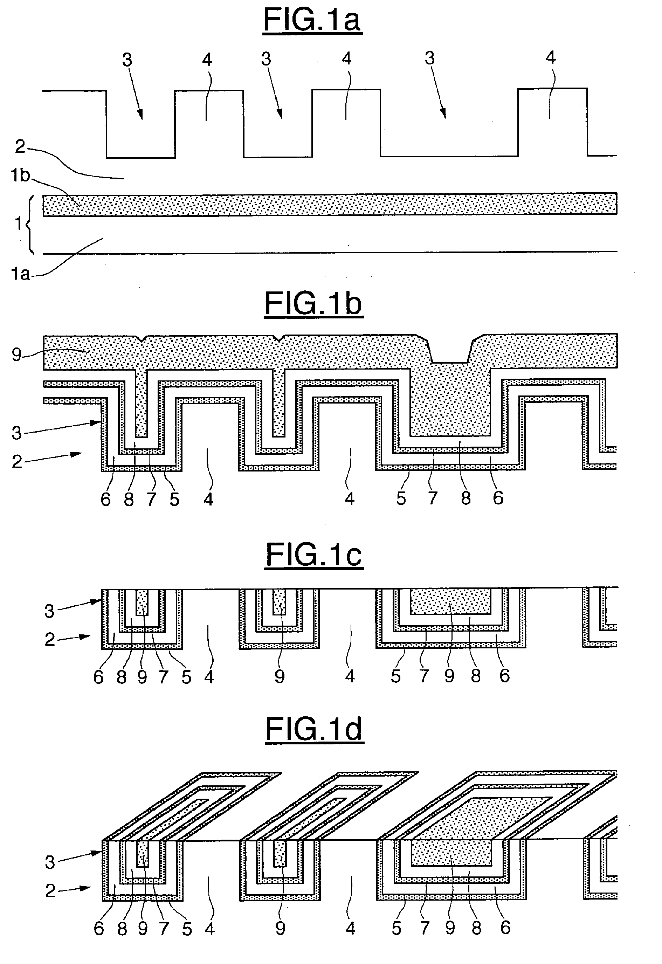

On dépose alors successivement,comme le montre la figure 1b, des couches alternées de Si₁₋ₓGeₓ 5, 7 et Si 6, 8 sur la surface supérieure de la couche 2, plus particulièrement des saillies 4 limitant les tranchées, et les parois des tranchées 3. Bien évidemment le nombre de couches alternées successives dépendra de l'épaisseur de ces couches et du dispositif final voulu.

Dans l'exemple de mise en oeuvre du procédé représenté, les couches successives alternées ne remplissent pas totalement les tranchées mais y laissent un évidement, et on dépose toujours de manière classique, par exemple par CVD, une couche d'un matériau diélectrique 9 tel que du SiO₂ ou du Si₃N₄ de manière à remplir les évidements des tranchées et recouvrir les couches alternées 5 à 8.

A ce stade du procédé on effectue un polissage mécano-chimique classique de façon à enlever des parties superficielles de la couche de matériau diélectrique 9 et des couches successives alternées 5 à 8 pour obtenir une hétérostructure ayant une surface supérieure plane au niveau de laquelle affleurent, comme le montrent les figures 1c et 1d, les couches successives alternées 5 à 8 et la couche de matériau diélectrique 9.

On obtient ainsi à la surface supérieure plane des zones adjacentes de différents matériaux combinés pour réaliser le dispositif voulu. Après réalisation de manière classique de zones de contact prédéterminées, on obtient des dispositifs fonctionnant dans le plan, tels que des puits quantiques permettant une détection à différentes longueurs d'onde avec une illumination normale à la surface, c'est-à-dire sans absorption dans les différentes couches, et ce, grâce à différentes largeurs de tranchées.

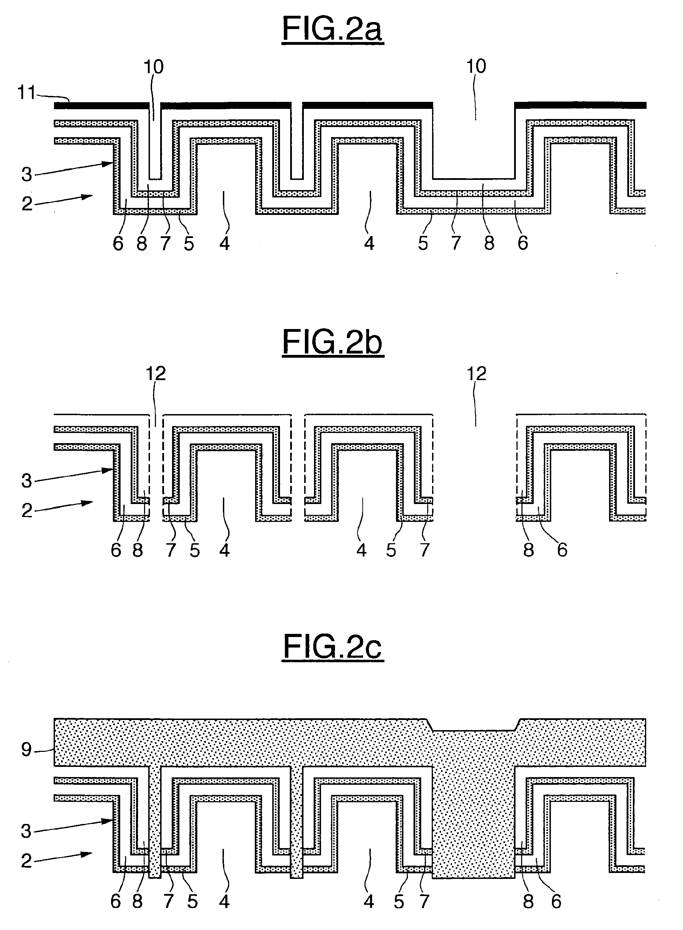

Les figures 2a à 2e, sur lesquelles les mêmes numéros de références représentent les mêmes éléments, illustrent un second mode de mise en oeuvre du procédé de l'invention.

Comme le montre la figure 2a, après avoir réalisé comme précédemment une structure comprenant une couche de Si ou Ge 2 comportant des tranchées 3 et revêtue de couches successives alternées de Si₁₋ₓGeₓ et Si également comme décrit en liaison avec les figures 1a à 1d, on revêt de façon classique , par exemple par photolithographie, la surface supérieure de la structure d'un masque de résine 11 de motif approprié, laissant apparent les parties non remplies ou évidements 10 des tranchées. Cette photolithographie n'est pas critique car elle a lieu en dehors des zones actives du dispositif.

On grave ensuite la structure de manière classique pour dégager les fonds des parties non remplies des tranchées et ainsi former des évidements prolongés 12 pénétrant jusque dans la couche de Si ou Ge 2.

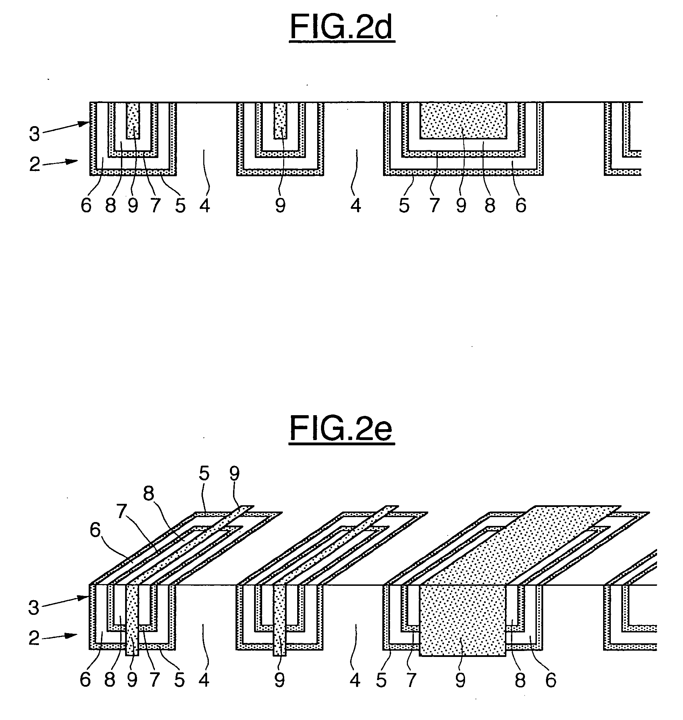

On procède alors comme précédemment en déposant une couche 9 de matériau isolant de manière à remplir les évidements prolongés 12 afin d'isoler les différentes zones actives (figure 2c) et à un polissage mécano-chimique pour obtenir l'hétérostructure planaire représentée aux figures 2d et 2e. '

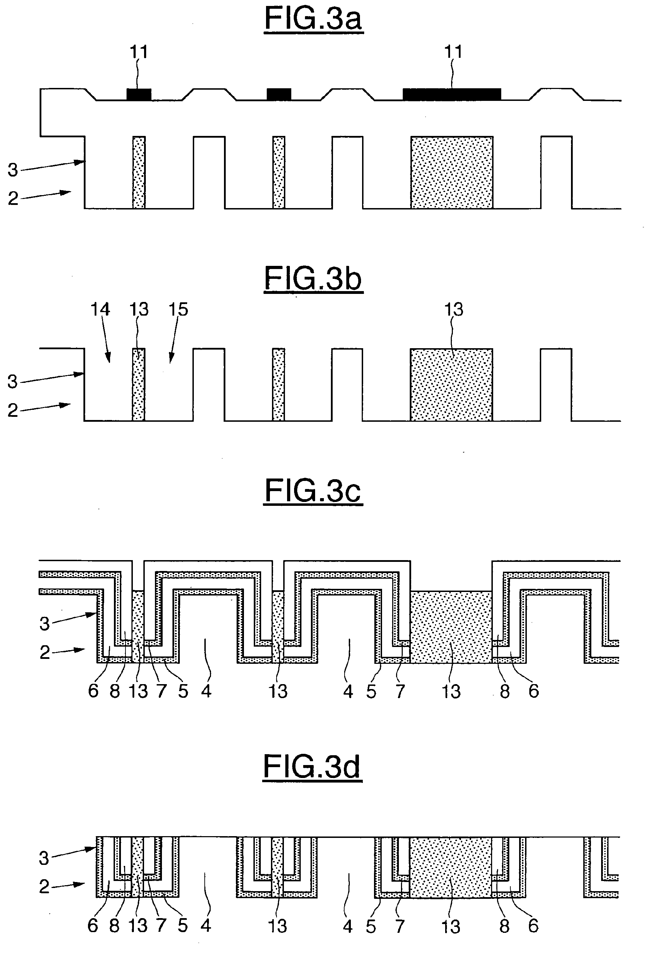

Les figures 3a à 3d, où les mêmes numéros de référence représentent les mêmes éléments, illustrent schématiquement un autre mode de réalisation de l'isolation des zones actives d'une hétérostructure planaire selon l'invention.

Comme le montre la figure 3a, après avoir formé des tranchées dans une couche 2 de Si ou Ge on remplit les tranchées et recouvrent la couche 2 avec un matériau diélectrique 9. Puis on réalise de manière classique sur la couche 9 de matériau diélectrique un motif prédéterminé d'une résine de masquage 11.

Comme le montre la figure 3b, le motif de résine 11 est tel, qu'après gravure , il ne reste de la couche de matériau diélectrique 9 que des parois 13, par exemple centrales, d'épaisseur prédéterminée divisant les tranchées en deux demi-tranchées 14,15.

On procède alors au dépôt des couches alternées successives de Si et SiGe 5-8 dans les demi-tranchées et sur la surface de la couche 2 (figure 3c) puis à un polissage mécano-chimique pour obtenir l'hétérostructure planaire de la figure 3d.

### Exemples de réalisations à base de multi-puits quantiques.

### -Fabrication de fils quantiques :

Epaisseurs des couches alternées

| | |
|---|---|
| SiGe (teneur en Ge de 15-20 % at.) | <10 nm |
| Ge | 0,5 à 5 nm |
| Si | ≤10 nm |

Multicouches SiGe/Si :X périodes

Largeur de la tranchée : e = [X(20+10)]x2

Profondeur de la tranchée dans le substrat : p>500 nm (p>e)

PMC jusqu'à affleurement de toutes les couches

Couche d'encapsulation éventuelle en matériau diélectrique ou Si.

### -Détecteur à base de SiGe/Si :

Même structure que ci-dessus avec en plus une alternance de tranchées à pas variable adjacentes dont la somme est inférieure à l'aire du spot lumineux (Réalisation de matrices de détection).

### -Fabrication d'une structure laser à base de Si :

Même structure que précédemment mais en ayant des largeurs de tranchées pour obtenir les trois niveaux de pompage d'une émission laser dans le plan.

## Revendications

1. Hétérostructure planaire comprenant :
- au moins une tranchée de largeur et de profondeur prédéterminées, gravée dans un substrat semiconducteur à partir d'une surface principale supérieure du substrat, la tranchée ayant une paroi de fond et des parois latérales verticales, et
- un empilement de couches successives et alternées de Si₁₋ₓGeₓ (0<x≤1) et Si déposées sur les parois de fond et latérales de la tranchée et dont le nombre et l'épaisseur dépendent de l'utilisation finale envisagée pour l'hétérostructure,
l'hétérostructure finale ayant une surface principale supérieure plane au niveau de laquelle affleurent les couches de l'empilement déposées dans la tranchée.

2. Hétérostructure planaire selon la revendication 1 dans lequel le substrat comprend plusieurs tranchées.

3. Hétérostructure planaire selon la revendication 2 dans lequel les tranchées sont de largeurs identiques ou différentes.

4. Hétérostructure planaire selon l'une des revendications 1 à 3 dans lequel le substrat est un substrat en silicium massif ou en couche mince, ou en germanium massif ou en couche mince.

5. Hétérostructure planaire selon l'une des revendications 1 à 4 dans lequel l'empilement des couches successives alternées ne remplit pas la tranchée en totalité, l'hétérostructure planaire comprenant une couche déposée de matériau diélectrique pour remplir la tranchée.

6. Hétérostructure planaire selon l'une des revendications 1 à 4 dans lequel l'empilement des couches successives alternées dans la tranchée laisse un évidement dans la tranchée, l'évidement étant prolongé jusque dans le matériau du substrat par gravure de l'empilement et l'hétérostructure planaire comprenant une couche déposée de matériau diélectrique de façon à remplir l'évidement prolongé.

7. Hétérostructure planaire selon l'une des revendications 1 à 4 comprenant dans la tranchée une paroi d'épaisseur prédéterminée divisant la tranchée en deux demi-tranchées, l'hétérostructure planaire comprenant un empilement de couches successives et alternées de Si₁₋ₓGeₓ (0<x≤1) et Si déposées sur les parois de fond et latérales des deux demi-tranchées et remplissant les deux demi-tranchées.

8. Hétérostructure planaire selon l'une des revendications 1 à 7 dans lequel les parois latérales de la tranchée sont à un angle de 70° à 80° par rapport au plan de la surface principale supérieure.

9. Hétérostructure planaire selon l'une des revendications 1 à 8 dans lequel les parois latérales de la tranchée sont de qualité monocristalline.

10. Dispositif électronique comprenant une hétérostructure planaire selon l'une des revendications 1 à 9.

11. Dispositif électronique selon la revendication 10 fonctionnant dans le plan.

12. Dispositif électronique selon la revendication 11 dans lequel le dispositif électronique est un puit quantique.

13. Procédé de fabrication d'une hétérostucture planaire, **caractérisé en ce qu'**il comprend :
a) la gravure dans un substrat semiconducteur (2), à partir d'une surface principale supérieure du substrat, d'au moins une tranchée de largeur et de profondeur prédéterminées ayant une paroi de fond et des parois latérales verticales;
b) le dépôt par hétéro-épitaxie ou épitaxie par voie de dépôt chimique en phase vapeur (CVD), sur la surface principale supérieure du substrat et les parois de fond et latérales de la tranchée, d'un empilement de couches successives et alternées de Si₁₋ₓGeₓ (0 < x ≤ 1) et Si (5-8) dont le nombre et l'épaisseur dépendent de l'utilisation finale envisagée pour l'hétérostructure; et
c) le polissage mécano-chimique pour obtenir une hétérostructure finale ayant une surface principale supérieure plane au niveau de laquelle affleurent les couches de l'empilement déposées dans la tranchée.
